# EUROPÄISCHE PATENTSCHRIFT

(11) **EP 3 560 306 B1**
(45) Veröffentlichungstag und Bekanntmachung des Hinweises auf die Patenterteilung: **30.09.2020**
(21) Anmeldenummer: 17808452.1
(22) Anmeldetag: 01.12.2017
(51) Int. Cl.: H05K 7/14, G01D 11/24

(54) **TRANSMITTERGEHÄUSE MIT DECKEL UND DECKELSICHERUNG**
TRANSMITTER HOUSING WITH LID AND LID SECURING MEANS
BOITTIER DE TRANSMETTEUR AVEC COUVERCLE ET SÉCURITÉ DE COUVERCLE

(30) Priorität: 22.12.2016 DE 202016107260 U
(43) Veröffentlichungstag der Anmeldung: 30.10.2019
(73) Patentinhaber: Endress+Hauser SE+Co. KG, 79689 Maulburg (DE)
(72) Erfinder: TANNER, Jürgen, 79400 Kandern (DE); SCHONHARDT, Raphael, 79618 Rheinfelden (DE); DI COSOLA, Vitogiuseppe, 79258 Hartheim (DE)
(74) Vertreter: Andres, Angelika Maria
(86) Internationale Anmeldenummer: PCT/EP2017/081134
(87) Internationale Veröffentlichungsnummer: WO 2018/114284

(56) Entgegenhaltungen:
- EP-A1- 0 910 441
- WO-A1-2006/045770
- DE-A1-102008 001 865
- US-A1- 2012 063 065

## Beschreibung

Die Erfindung betrifft ein Transmittergehäuse eines Feldgeräts der Automatisierungstechnik, wobei das Transmittergehäuse mit einer Deckelsicherung versehen und durch einen aufgeschraubten Deckel verschlossen ist.

In der Automatisierungstechnik werden Feldgeräte zur Bestimmung und/oder Überwachung von Prozessgrößen eingesetzt. Als Feldgeräte werden im Rahmen der vorliegenden Anmeldung im Prinzip alle Messgeräte bezeichnet, die prozessnah eingesetzt werden und die prozessrelevante Informationen liefern oder verarbeiten. Dabei handelt es sich beispielsweise um Füllstandsmessgeräte, Durchflussmessgeräte, Druck- und Temperaturmessgeräte, pH-Redoxpotentialmessgeräte, Leitfähigkeitsmessgeräte, usw., welche die entsprechenden Prozessgrößen Füllstand, Durchfluss, Druck, Temperatur, pH-Wert bzw. Leitfähigkeit erfassen. Solche Feldgeräte werden in unterschiedlichen Ausgestaltungen von der E+H Gruppe hergestellt und vertrieben.

Die Feldgeräte weisen dabei eine in einem Transmittergehäuse des Feldgeräts angeordnete Elektronikeinheit auf. Die Elektronikeinheit dient zum Beispiel der Erzeugung eines die Prozessgröße repräsentierenden elektrischen Signals, wie beispielsweise einer Spannung und/oder eines Stroms und/oder der Weiterleitung der erzeugten elektrischen Signals. Das Transmittergehäuse ist dabei durch einen Deckel verschlossen. In vielen Fällen weist das Transmittergehäuse auch einen voneinander getrennten Anschluss- und Elektronikraum auf, welche jeweils durch einen Deckel nach außen verschlossen sind.

Derartige Feldgeräte, die auch in explosionsgefährdeten Bereichen betrieben werden sollen, müssen sehr hohen Sicherheitsanforderungen hinsichtlich des Explosionsschutzes genügen. Dabei geht es im Besonderen darum, die Bildung von Funken sicher zu vermeiden oder zumindest sicherzustellen, dass ein im Fehlerfall entstandener Funke keine Auswirkungen auf die Umgebung hat. Hierfür sind entsprechenden Normen in dazugehörigen Schutzklassen definiert. In der Schutzklasse mit dem Namen "Eigensicherheit" (Ex-i) wird der Explosionsschutz dadurch erzielt, dass die Werte für eine elektrische Größe (Strom, Spannung, Leistung) zu jeder Zeit jeweils unterhalb eines jeweils vorgegebenen Grenzwertes liegen, damit auch im Fehlerfall kein Zündfunken erzeugt wird. In der weiteren Schutzklasse mit dem Namen "Erhöhte Sicherheit" (Ex-e) wird der Explosionsschutz dadurch erzielt, dass die räumlichen Abstände zwischen zwei verschiedenen elektrischen Potentialen so groß sind, dass eine Funkenbildung auch im Fehlerfall aufgrund der Distanz nicht auftreten kann. In der weiteren Schutzklasse mit dem Namen "Druckfeste Kapselung" (Ex-d) müssen Feldgeräte, die gemäß dieser Schutzklasse ausgebildet sind, ein druckfestes Transmittergehäuse mit einer ausreichenden mechanischen Festigkeit bzw. Stabilität aufweisen.

Zum Zweckes des Explosionsschutzes, insbesondere gemäß der Ex-d Schutzklasse, sind zusätzliche mechanische Sicherungen für den das Transmittergehäuse verschließenden Deckel zwingend vorgeschrieben. Die Deckelsicherung am Feldgerät verhindert ein gegebenenfalls unbeabsichtigtes Öffnen des jeweiligen Deckels dadurch, dass zum Öffnen des Deckels eine zusätzliche, den Deckel sichernde Schraube bewusst gelöst werden muss.

Die im Stand der Technik bekannten Deckelsicherungen sind dabei zum Beispiel als eine von außen an das Transmittergehäuse angebrachte und mit einer Schraube verschlossene Klemme ausgestaltet. Hierbei ist das Transmittergehäuse zur Aufnahme der Klemme und/oder der Schraube oftmals speziell geformt. Nachteilig an dieser Lösung ist, dass eine derartige Klemme bzw. Schraube gegenüber dem Transmittergehäuse erhaben ist. Für den Fall, dass die Schraube der Deckelsicherung freiliegt, kann sich in dem Schraubenkopf und/oder dem Gewinde der Schraube, beispielsweise im Falle hoher Umgebungsfeuchtigkeit, Flüssigkeit ansammeln. Diese wirkt korrodierend auf den Schraubenkopf bzw. das Gewinde ein und kann dadurch letztendlich zu einem Versagen der Deckelsicherung führen. Weiterhin kann es zu einer durch den Kontakt zwischen der Klemme und dem Transmittergehäuse bedingten Korrosion (sogenannten Kontaktkorrosion) kommen, die durch die Beschädigung der Lackschicht am Deckel und am Transmittergehäuse ausgelöst wird.

Die US2012/063065 offenbart ein Feldgerät mit einem aufschraubbaren Deckel.

Der Erfindung liegt die Aufgabe zugrunde, eine korrosionsbeständige Deckelsicherung für ein Transmittergehäuse eines Feldgeräts der Automatisierungstechnik anzugeben.

Die Erfindung wird gelöst durch eine Deckelsicherung für ein Transmittergehäuse eines Feldgeräts der Automatisierungstechnik, wobei das Transmittergehäuse durch einen aufgeschraubten Deckel verschlossen ist, umfassend: einen Sicherungsstift mit einer an einem ersten Endbereich des Sicherungsstift angeordneten Schraube, eine in den Deckel integrierte Führung, die dazu ausgestaltet ist, den Sicherungsstift aufzunehmen; und eine Nut, die einen kreissegmentförmigen Abschnitt umfasst und die in einen dem Deckel zugewandten Bereich des Transmittergehäuses eingebracht ist.

Der Sicherungsstift ist von einer dem Transmittergehäuse abgewandten Stirnseite des Deckels her derart in der Führung befestigbar, dass im befestigten Zustand ein dem ersten Endbereich gegenüberliegender zweiter Endbereich des Sicherungsstiftes in die Nut hineinragt, wodurch eine Verdrehung des auf das Transmittergehäuse aufgeschraubten Deckels gegenüber dem Transmittergehäuse einschränkt ist.

Gemäß der Erfindung ist die in den Deckel integrierte Schraube vor Korrosion weitestgehend geschützt. Ein weiterer Vorteil an der Erfindung besteht darin, dass ein Transmittergehäuse ohne eine derartige Deckelsicherung mittels einer sehr einfachen, nachträglichen Bearbeitung von Transmittergehäuse und Deckel zu einem Transmittergehäuse mit einer Deckelsicherung nachgerüstet werden, ohne dass ein speziell geformtes Transmittergehäuse benötigt wird. Hierfür muss nur nachträglich die Führung in den Deckel und die Nut in das Transmittergehäuse eingebracht werden. Ein Transmittergehäuse kann dadurch ausgehend von demselben im Wesentlichen gleich geformten Ausgangsgehäuse mit oder ohne Deckelsicherung hergestellt werden. Dadurch wird ein hoher Modularisierungsgrad in der Gehäusefertigung erreicht, wodurch wiederum Herstellungskosten herabgesenkt werden.
In einer Ausgestaltung der Erfindung sind der Deckel und das Transmittergehäuse zumindest bereichsweise zylinderförmig, wobei der Deckel mit seinem zylinderförmigen Bereich auf den zylinderförmigen Bereich des Transmittergehäuse geschraubt ist.

In einer Ausgestaltung der Erfindung verläuft der kreissegmentförmige Abschnitt um einen gedachten Kreismittelpunkt des zylinderförmigen Bereichs des Transmittergehäuses derart, dass der in die Führung eingeschraubte Sicherungsstift im eingesetzten Zustand die Verdrehung des aufgeschraubten Deckels gegenüber dem Transmittergehäuse auf einen kreissegmentförmigen Abschnitt mit einem Segmentwinkel (α), der denkreissegmentförmigen Abschnitt um den gedachten Mittelpunkt aufspannt, einschränkt, wobei der Segmentwinkel (α) kleiner als 120° ist.

In einer weiteren Ausgestaltung der Erfindung beträgt der Segmentwinkel (α) zwischen 30° und 90°. Insbesondere beträgt der Segmentwinkel (α) zwischen 50° und 70°. Vorzugsweise beträgt der Segmentwinkel (α) 60°.

In einer Ausgestaltung ist der Sicherungsstift aus einem duktilen Material gebildet. Duktilität bezeichnet die Eigenschaft eines Werkstoffs, sich unter Belastung plastisch zu verformen, bevor er bricht.

In einer Ausgestaltung der Erfindung ist der Sicherungsstift aus einem Metall oder einer metallischen Legierung gebildet. Insbesondere ist der Sicherungsstift aus einem Stahl gebildet. Vorzugsweise handelt es sich dabei um einen ausgehärteten Stahl.

In einer Ausgestaltung ist der Sicherungsstift durch die Schraube einschraubbar.

In einer bevorzugten Weiterbildung der Erfindung ist die Nut derart auf die Ausgestaltung des Sicherungsstiftes abgestimmt, dass zwischen dem zweiten Endbereich eines in die Führung eingesetzten Sicherungsstifts und einem Nutgrund der Nut ein Spalt gebildet ist, insbesondere ein durch eine Tiefe der Nut bedingter Spalt. In dieser bevorzugten Ausgestaltung berührt daher der Sicherungsstift nicht den Nutgrund. Dadurch wird z.B. vorteilhaft verhindert, dass eine auf das beispielsweise metallische Transmittergehäuse aufgebrachte Lackierung (zum Korrosionsschutz des Transmittergehäuses) durch den Sicherungsstift beschädigt wird, etwa durch einen Abrieb der Lackierung durch den zweiten Endbereich des Sicherungsstifts.
In einer Ausgestaltung der Erfindung erstreckt sich der erste Endbereich des in die Führung eingesetzten Sicherungsstiftes in einer dem Transmittergehäuse abgewandten Richtung höchstens bis zu der dem Transmittergehäuse abgewandten Stirnseite des Deckels. Dadurch ragt der erste Endbereich nicht nach außen aus dem Deckel hervor, und ist dadurch besonders gegenüber Umweltbedingungen wie beispielsweise hoher Feuchtigkeit und der dadurch verursachten Korrosion geschützt.

In einer vorteilhaften Weiterbildung dieser Ausgestaltung weist die Schraube des in die Führung eingesetzten Sicherungsstiftes einen Versatz von zumindest 2mm zu der dem Transmittergehäuse abgewandten Stirnseite des Deckels auf.

In einer Ausgestaltung der Erfindung ist die Führung in den Deckel gebohrt.

In einer Ausgestaltung der Erfindung ist die Nut in das Transmittergehäuse gebohrt oder gefräst.

In einer vorteilhaften Weiterbildung der Erfindung ist ein die Führung abdichtendes Dichtelement zwischen dem Transmittergehäuse und dem Sicherungsstift angeordnet.

In einer Ausgestaltung dieser Weiterbildung handelt es sich bei dem Dichtelement um einen den Sicherungsstift an seinem ersten Endbereich ringförmig umgebenden O- Ring.

In einer Ausgestaltung besteht das Dichtelement aus einen Kunststoff. Insbesondere besteht das Dichtelement aus einem Elastomer.

Die Erfindung wird anhand der nachfolgenden Figuren näher erläutert. Gleiche Bezugszeichen bezeichnen gleiche Merkmale; wenn es die Übersichtlichkeit erfordert oder es anderweitig sinnvoll erscheint, wird auf bereits erwähnte Bezugszeichen in nachfolgenden Figuren verzichtet. Es zeigt:
Fig. 1: Eine Aufsicht auf ein Transmittergehäuse mit einer Nut in einer Ausgestaltung der erfindungsgemäßen Deckelsicherung;
Fig. 2: Eine Schnittansicht eines Sicherungsstiftes in einer Ausgestaltung der erfindungsgemäßen Deckelsicherung;
Fig. 3a: Eine perspektivische Ansicht einer Ausgestaltung der erfindungsgemäßen Deckelsicherung;
Fig. 3b: Eine Schnittansicht der in Fig. 3a gezeigten Ausgestaltung der erfindungsgemäßen Deckelsicherung;
Fig. 4: Eine perspektivische Ansicht einer Ausgestaltung der erfindungsgemäßen Deckelsicherung.

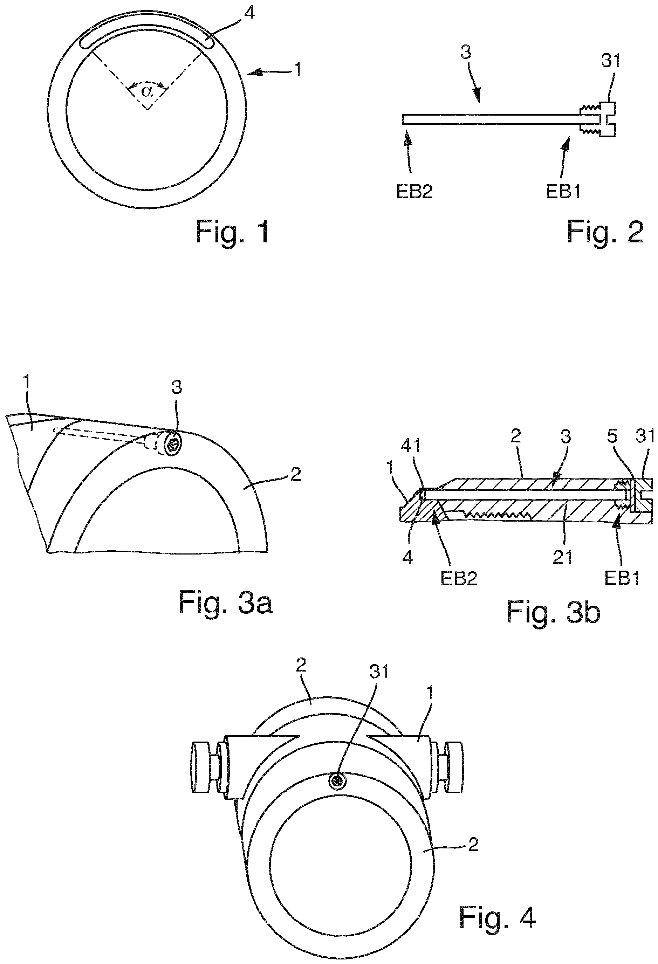

In Fig. 1 ist eine Aufsicht auf den dem Deckel 2 zugewandten Bereich des Transmittergehäuses 1 in einer Ausgestaltung der erfindungsgemäßen Deckelsicherung gezeigt. Dargestellt ist die Nut 4, die in eine dem Deckel 2 zugewandte Wand des Transmittergehäuses 1 eingebracht ist. Die Nut 4 umfasst einen kreissegmentförmigen Abschnitt um einen gedachten Kreismittelpunkt des Transmittergehäuses 1 mit einem Segmentwinkel a. Der in die Führung 21 eingeschraubte Sicherungsstift 3 (hier nicht dargestellt) schränkt im eingesetzten Zustand die Verdrehung des aufgeschraubten Deckels 2 (hier nicht dargestellt) gegenüber dem Transmittergehäuse 1 auf den Segmentwinkel α ein.

In Fig. 2 ist eine Schnittansicht des Sicherungsstiftes 3 dargestellt. Der Sicherungsstift 3 wird in einem Stück gefertigt oder alternativ mittels einem stoffschlüssigen Verbinden, beispielsweise ein Verschweißen, aus einem vorgefertigten Stift und einer vorgefertigten Schraube 31 hergestellt. Der Sicherungsstift 3 umfasst einen ersten Endbereich EB1, an dem die Schraube 31 angeordnet ist, sowie einen zweiten Endbereich EB2, der dem ersten Endbereich EB1 gegenüberliegt. Der zweite Endbereich EB2 des Sicherungsstiftes 3 ragt im eingesetzten Zustand in die Nut 4 hinein.

Dies ist in Fig. 3a zu erkennen, welche eine perspektivische Ansicht einer Ausgestaltung der erfindungsgemäßen Deckelsicherung zeigt. Der Sicherungsstift 3 ist hier in die Führung 21, welche in den Deckel 2 eingebracht ist, eingeschraubt. Dazu weist die Führung 21 an einem Endbereich, der dem Transmittergehäuse 1 abgewandt ist, ein Gewinde auf, in das die Schraube 31 des Sicherungsstiftes 3 eingeschraubt ist.

Der eingeschraubte Sicherungsstift 3 beschränkt eine Verdrehung des Deckels 2 gegenüber dem Transmittergehäuse 1 auf einen Segmentwinkel α (vgl. Fig. 1), der in diesem Ausführungsbeispiel 60° beträgt. Diese Verdrehung des Deckels 2 gegenüber dem Transmittergehäuse 1 reicht nicht für ein Aufschrauben des Deckels 2 aus. Der Segmentwinkel α erlaubt damit eine gewisse Schwankung in Bezug auf die Ausrichtung des Sicherungsstiftes 3 gegenüber der Nut 4, welche beispielsweise durch Schwankungen in der Fertigung erforderlich sind.

Um den Deckel 2 vollständig auszuschrauben muss wie in der Ex-d Schutzklasse gefordert zunächst die Schraube 31 gelöst und anschließend der Sicherungsstift in Richtung der dem Transmittergehäuse 1 abgewandten Stirnseite des Deckels 2 verschoben werden. Damit wird durch den eingeschraubten Sicherungsstift 3 der auf das Transmittergehäuse 1 aufgeschraubte Deckel 2 gesichert.

Der in die Führung 21 eingesetzte Sicherungsstift 3 aus Fig. 3a ist in einer Schnittansicht in Fig. 3b näher dargestellt. Hierbei ist der Spalt zwischen dem zweiten Endbereich EB2 des Sicherungsstiftest 3 und dem Nutgrund 41 der Nut 4 erkennbar. Dadurch berührt der Sicherungsstift 3 selbst nicht in dem in die Führung 21 eingesetzten Zustand die Nut 4 in dem Nutgrund 41, wodurch das Risiko einer Beschädigung des Lacks, mit dem das Transmittergehäuse 1 beschichtet ist, vermindert wird. Dies ist wichtig, da dieser Lack unter anderem als Korrosionsschutzschicht für das Transmittergehäuse dient. Nur bei dem Versuch, den durch die Deckelsicherung gesicherten Deckel 2 aufzuschrauben, stößt der Sicherungsstift 3 seitlich an die Endbereiche der Nut 4. Dadurch wird ein weiteres Verdrehen des Deckels gegenüber dem Transmittergehäuse 1 welches über den Segmentwinkel α hinausgeht (vgl. Fig. 1) verhindert. Dadurch ist ein Aufschrauben des mit der erfindungsgemäßen Deckelsicherung gesicherten Deckels 2 ausgeschlossen.

In dieser Ausgestaltung ist hier zusätzlich ein Dichtelement 5 vorgesehen, bei dem es sich um einen aus einem Elastomer gebildeten O-Ring handelt. Das Dichtelement 5 befindet sich vorzugsweise an dem ersten Endbereich EB1 zwischen der Schraube 31 und dem Transmittergehäuse 1. Dadurch ist die Führung 21 gegenüber Feuchtigkeitseinbrüchen zusätzlich abgedichtet.

Ein weiterer Vorteil der erfindungsgemäßen Deckelsicherung besteht darin, dass der Sicherungsstift 3 selbst im aufgeschraubten Zustand nicht der Führung 21 vollständig entnommen werden muss. Nach dem Aufschrauben kann der Sicherungsstift 3 nur insoweit in Richtung der dem Transmittergehäuse 1 abgewandten Stirnseite des Deckels 2 verschoben werden, dass der zweite Endbereich EB2 des Sicherungsstiftes 3 nicht mehr in die Nut 4 eingreift. Durch dieses Verschieben der gelösten Deckelsicherung wird das Aufschrauben des Deckels 3 ermöglicht. Da der Sicherungsstift 3 nur verschoben ist, ist die Wahrscheinlichkeit für ein Herausfallen des Sicherungsstiftes 3 deutlich reduziert. Ein derartiges Herausfallen könnte ansonsten zu einem vollständigen Verlust des Sicherungsstiftes 3 und damit der Deckelsicherung führen, beispielsweise für den Fall, dass das Feldgerät in schwer zugänglichen Bereichen betrieben wird.

Fig. 4 zeigt eine perspektivische Ansicht eines Transmittergehäuses 1 eines Feldgeräts mit zwei erfindungsgemäßen Deckelsicherungen für jeweils zwei das Transmittergehäuse 1 an jeweils unterschiedlichen Endbereichen verschließende Deckel 2. Von außen erkennbar ist nur der Schraubenkopf der Schraube 31 des Sicherungsstiftes 3, welcher einen ersten der beiden Deckel 2 sichert. Der Schraubenkopf des Sicherungsstiftes ist um einen kleinen Versatz von 3mm gegenüber der von dem Transmittergehäuse 1 abgewandten Stirnseite des Deckels 2 in Richtung des Transmittergehäuses 1 abgesetzt. Der Schraubenkopf der Schraube 31 des Sicherungsstiftes 3 kann dabei (unabhängig von der hier gezeigten Ausgestaltung) zusätzlich noch mit einer weiteren Korrosionsschutzschicht, beispielsweise aus Gold, überzogen sein.

## Patentansprüche

1. Transmittergehäuse (1) eines Feldgeräts der Automatisierungstechnik, mit einem aufgeschraubten Deckel (2) und einer Deckelsicherung, wobei das Transmittergehäuse (1) durch den aufgeschraubten Deckel (2) verschlossen ist, umfassend:
einen Sicherungsstift (3) mit einer an einem ersten Endbereich (EB1) des Sicherungsstift (3) angeordneten Schraube (31);
eine in den Deckel (2) integrierte Führung (21), die dazu ausgestaltet ist, den Sicherungsstift (3) aufzunehmen; und
eine Nut (4), die einen kreissegmentförmigen Abschnitt umfasst und die in einen dem Deckel (2) zugewandten Bereich des Transmittergehäuses (1) eingebracht ist;
wobei der Sicherungsstift (3) von einer dem Transmittergehäuse (1) abgewandten Stirnseite des Deckels (2) her derart in der Führung (21) befestigbar ist, dass im befestigten Zustand ein dem ersten Endbereich (EB1) gegenüberliegender zweiter Endbereich (EB2) des Sicherungsstiftes (3) in die Nut (4) hineinragt, wodurch eine Verdrehung des auf das Transmittergehäuse (1) aufgeschraubten Deckels (2) gegenüber dem Transmittergehäuse (1) einschränkt ist.

2. Transmittergehäuse nach Anspruch 1, wobei der Deckel (2) und das Transmittergehäuse (1) zumindest bereichsweise zylinderförmig sind und der Deckel (2) mit seinem zylinderförmigen Bereich auf den zylinderförmigen Bereich des Transmittergehäuse (1) geschraubt ist.

3. Transmittergehäuse nach Anspruch 2, wobei der kreissegmentförmige Abschnitt um einen gedachten Kreismittelpunkt des zylinderförmigen Bereichs des Transmittergehäuses (1) derart verläuft, dass der in die Führung (21) eingeschraubte Sicherungsstift (3) im eingesetzten Zustand die Verdrehung des aufgeschraubten Deckels (2) gegenüber dem Transmittergehäuse (1) auf einen kreissegmentförmigen Abschnitt mit einem Segmentwinkel (α), der den kreissegmentförmige Abschnitt um den gedachten Mittelpunkt aufspannt, einschränkt, wobei der Segmentwinkel (α) kleiner als 120° ist.

4. Transmittergehäuse nach Anspruch 3, wobei der Segmentwinkel (α) zwischen 30° und 90°, insbesondere zwischen 50° und 70° , vorzugsweise 60°, beträgt.

5. Transmittergehäuse nach zumindest einem der vorherigen Ansprüche, wobei der Sicherungsstift (3) aus einem duktilen Material gebildet ist.

6. Transmittergehäuse nach zumindest einem der vorherigen Ansprüche, wobei der Sicherungsstift (3) aus einem Metall oder einer metallischen Legierung, insbesondere aus einem, vorzugsweise ausgehärteten, Stahl, gebildet ist.

7. Transmittergehäuse nach zumindest einem der vorherigen Ansprüche, wobei der Sicherungsstift (3) durch die Schraube (31) einschraubbar ist.

8. Transmittergehäuse nach zumindest einem der vorherigen Ansprüche, wobei die Nut (4) derart auf die Ausgestaltung des Sicherungsstiftes (3) abgestimmt ist, dass zwischen dem zweiten Endbereich (EB2) eines in die Führung (21) eingesetzten Sicherungsstifts (3) und einem Nutgrund (41) der Nut (4) ein Spalt gebildet ist, insbesondere ein durch eine Tiefe der Nut (4) bedingter Spalt.

9. Transmittergehäuse nach zumindest einem der vorherigen Ansprüche, wobei der erste Endbereich (EB1) des in die Führung (21) eingesetzten Sicherungsstiftes (3) sich in einer dem Transmittergehäuse (1) abgewandten Richtung höchstens bis zu der dem Transmittergehäuse (1) abgewandten Stirnseite des Deckels (2) erstreckt.

10. Transmittergehäuse nach Anspruch 9, wobei die Schraube (31) des in die Führung (21) eingesetzten Sicherungsstiftes (3) einen Versatz von zumindest 2mm zu der dem Transmittergehäuse (1) abgewandten Stirnseite des Deckels (2) aufweist.

11. Transmittergehäuse nach zumindest einem der vorherigen Ansprüche, wobei die Führung (21) in den Deckel (2) gebohrt ist.

12. Transmittergehäuse nach zumindest einem der vorherigen Ansprüche, wobei die Nut (4) in das Transmittergehäuse (1) gebohrt oder gefräst ist.

13. Transmittergehäuse nach zumindest einem der vorherigen Ansprüche, wobei ein die Führung (21) abdichtendes Dichtelement (5) zwischen dem Transmittergehäuse (1) und dem Sicherungsstift (3) angeordnet ist.

14. Transmittergehäuse nach Anspruch 13 wobei es sich bei dem Dichtelement (5) um einen den Sicherungsstift (3) an seinem ersten Endbereich (EB1) ringförmig umgebenden O- Ring handelt.

15. Transmittergehäuse nach Anspruch 13 oder 14, wobei das Dichtelement (5) aus einen Kunststoff, insbesondere aus einem Elastomer, besteht.

## Claims

1. Transmitter housing (1) of a field device used in automation engineering, with a screwed-on cover (2) and a cover lock, wherein the transmitter housing (1) is sealed by the screwed-on cover (2),
comprising:
a locking pin (3) with a screw (31) arranged on a first end section (EB1) of the locking pin (3);
a guide (21) integrated in the cover (2), said guide being designed to receive the locking pin (3); and
a groove (4), which comprises a section in the form of a circular segment and which is integrated in a section of the transmitter housing (1) facing towards the cover (2);
wherein the locking pin (3) can be fixed in the guide (21), from the direction of a front face of the cover (2) which is facing away from the transmitter housing (1), in such a way that - in the fixed state - a second end section (EB2) of the locking pin (3), which is located opposite the first end section (EB1), projects into the groove (4), which limits a rotation of the cover (2) in relation to the transmitter housing (1), said cover being screwed onto the transmitter housing (1).

2. Transmitter housing as claimed in Claim 1,
wherein the cover (2) and the transmitter housing (1) are at least partially cylindrical in shape and the cover (2) is screwed onto the cylindrical part of the transmitter housing (1) at its cylindrical section.

3. Transmitter housing as claimed in Claim 2,
wherein the section in the form of a circular segment extends around an imaginary circle center of the cylindrical section of the transmitter housing (1) in such a way that, when mounted, the locking pin (3) screwed into the guide (21) limits the rotation of the screwed-on cover (2) in relation to the transmitter housing (1) to a section, in the shape of a circle segment, with a segment angle (a) which spans the section in the form of a circular segment around the imaginary circle center, wherein the segment angle (α) is less than 120°.

4. Transmitter housing as claimed in Claim 3,
wherein the segment angle (α) is between 30° and 90°, particularly between 50° and 70°, preferably 60°.

5. Transmitter housing as claimed in at least one of the previous claims,
wherein the locking pin (3) is made from a ductile material.

6. Transmitter housing as claimed in at least one of the previous claims,
wherein the locking pin (3) is made from a metal or a metal alloy, particularly a steel, preferably a hardened steel.

7. Transmitter housing as claimed in at least one of the previous claims,
wherein the locking pin (3) can be screwed in with the screw (31).

8. Transmitter housing as claimed in at least one of the previous claims,
wherein the groove (4) is adapted to the design of the locking pin (3) in such a way that a gap is formed between the second end section (EB2) of a locking pin (3) inserted into the guide (21) and a groove base (41) of the groove (4), particularly a gap that depends on a depth of the groove (4).

9. Transmitter housing as claimed in at least one of the previous claims,
wherein the first end section (EB1) of the locking pin (3) inserted into the guide (21) extends in a direction facing away from the transmitter housing (1), at maximum as far as the front face of the cover (2) facing away from the transmitter housing (1).

10. Transmitter housing as claimed in Claim 9,
wherein the screw (31) of the locking pin (3) - introduced in the guide (21) - is offset by at least 2 mm in relation to the front face of the cover (2) facing away from the transmitter housing (1).

11. Transmitter housing as claimed in at least one of the previous claims,
wherein the guide (21) is drilled into the cover (2).

12. Transmitter housing as claimed in at least one of the previous claims,
wherein the groove (4) is drilled or milled into the transmitter housing (1).

13. Transmitter housing as claimed in at least one of the previous claims,
wherein a sealing element - which seals the guide (21) - is arranged between the transmitter housing (1) and the locking pin (3).

14. Transmitter housing as claimed in Claim 13,
wherein the sealing element (5) is an O-ring that surrounds the locking pin (3), in an annular manner, at the pin's first end section (EB1).

15. Transmitter housing as claimed in Claim 13 or 14,
wherein the sealing element (5) is made from a plastic, particularly an elastomer.

## Revendications

1. Boîtier de transmetteur (1) d'un appareil de terrain de la technique d'automatisation, avec un couvercle vissé (2) et une sécurité de couvercle, le boîtier de transmetteur (1) étant obturé au moyen du couvercle vissé (2), comprenant :
une goupille de sécurité (3) avec une vis disposée sur une première zone d'extrémité (EB1) de la goupille de sécurité (3) ;
un guide (21) intégré dans le couvercle (2), lequel guide est conçu pour recevoir la goupille de sécurité (3) ; et
une rainure (4), qui comprend une section en forme de segment de cercle et qui est intégrée dans une zone du boîtier de transmetteur (1) tournée vers le couvercle (2) ;
la goupille de sécurité (3) peut être fixée dans le guide (21), depuis une face frontale du couvercle (2) détournée du boîtier de transmetteur (1), de telle sorte qu'à l'état fixé, une deuxième zone d'extrémité (EB2) de la goupille de sécurité (3), laquelle zone est située à l'opposé de la première zone d'extrémité (EB1), pénètre dans la rainure (4), ce qui limite une rotation du couvercle (2) par rapport au boîtier de transmetteur (1), lequel couvercle est vissé sur le boîtier de transmetteur (1).

2. Boîtier de transmetteur selon la revendication 1,
pour lequel le couvercle (2) et le boîtier de transmetteur (1) sont au moins partiellement de forme cylindrique et le couvercle (2) est vissé avec sa zone de forme cylindrique sur la zone de forme cylindrique du boîtier de transmetteur (1).

3. Boîtier de transmetteur selon la revendication 2,
pour lequel la partie en forme de segment de cercle s'étend autour d'un centre de cercle imaginaire de la zone du boîtier de transmetteur (1), de telle sorte que la goupille de sécurité (3) vissée dans le guide (21), limite, à l'état monté, la rotation du couvercle vissé (2) par rapport au boîtier de transmetteur (1) à une partie en forme de segment de cercle avec un angle de segment (α), qui recouvre la partie en forme de segment de cercle autour du centre imaginaire, l'angle de segment (a) étant inférieur à 120°.

4. Boîtier de transmetteur selon la revendication 3,
pour lequel l'angle de segment (a) s'élève entre 30° et 90°, notamment entre 50° et 70°, de préférence 60°.

5. Boîtier de transmetteur selon au moins l'une des revendications précédentes,
pour lequel la goupille de sécurité (3) est constituée d'un matériau ductile.

6. Boîtier de transmetteur selon au moins l'une des revendications précédentes,
pour lequel la goupille de sécurité (3) est constituée d'un métal ou d'un alliage métallique, notamment d'un acier, de préférence trempé.

7. Boîtier de transmetteur selon au moins l'une des revendications précédentes,
pour lequel la goupille de sécurité (3) peut être vissée à travers la vis (31).

8. Boîtier de transmetteur selon au moins l'une des revendications précédentes,
pour lequel la rainure (4) est adaptée à la forme de la goupille de sécurité (3) de telle sorte qu'une fente soit formée entre la deuxième zone d'extrémité (EB2) d'une goupille de sécurité (3) insérée dans le guide (21) et un fond de rainure (41) de la rainure (4), notamment une fente liée à une profondeur de la rainure (4).

9. Boîtier de transmetteur selon au moins l'une des revendications précédentes,
pour lequel la première zone d'extrémité (EB1) de la goupille de sécurité (3) insérée dans le guide (21) s'étend dans une direction opposée au boîtier de transmetteur (1), au maximum jusqu'à la face frontale du couvercle (2) détournée du boîtier de transmetteur (1).

10. Boîtier de transmetteur selon la revendication 9,
pour lequel la vis (31) de la goupille de sécurité (3) - introduite dans le guide (21) - est décalée d'au moins 2 mm vers la face frontale du couvercle (2) détournée du boîtier de transmetteur (1).

11. Boîtier de transmetteur selon au moins l'une des revendications précédentes,
pour lequel le guide (21) est percé dans le couvercle (2).

12. Boîtier de transmetteur selon au moins l'une des revendications précédentes,
pour lequel la rainure (4) est percée ou fraisée dans le boîtier de transmetteur (1).

13. Boîtier de transmetteur selon au moins l'une des revendications précédentes,
pour lequel un élément d'étanchéité - lequel élément assure l'étanchéité du guide (21) - est disposé entre le boîtier de transmetteur (1) et la goupille de sécurité (3).

14. Boîtier de transmetteur selon la revendication 13,
pour lequel il s'agit, concernant l'élément d'étanchéité (5), d'un joint torique entourant de façon annulaire la première zone d'extrémité (EB1) de la goupille de sécurité (3).

15. Boîtier de transmetteur selon la revendication 13 ou 14,
pour lequel l'élément d'étanchéité (5) est constitué d'une matière plastique, notamment un élastomère.
